Europäisches Patentamt

European Patent Office

Office européen des brevets

(11) Veröffentlichungsnummer: **0 579 911 A2**

# EUROPÄISCHE PATENTANMELDUNG

(21) Anmeldenummer: **93107038.7**

(22) Anmeldetag: **30.04.93**

(51) Int. Cl.5: **B22F 3/22**

(30) Priorität: **27.05.92 DE 4217531**

(43) Veröffentlichungstag der Anmeldung:
**26.01.94 Patentblatt 94/04**

(84) Benannte Vertragsstaaten:
**DE FR GB IT**

(71) Anmelder: **WIELAND-WERKE AG**
**Postfach 4240,**
**Graf-Arco-Strasse 34**
**D-89079 Ulm(DE)**

(72) Erfinder: **Dürrschnabel, Wolfgang, Dr.**
**Am Schlossberg 4**
**W-7919 Bellenberg(DE)**
Erfinder: **Müller, Gert, Dr.**
**Rudolfstrasse 4**
**W-7910 Neu-Ulm 4(DE)**
Erfinder: **Siegele, Harald, Dipl.-Chem.**
**Nibelungenstrasse 9**
**W-7917 Vöhringen(DE)**

(54) **Verfahren zur Herstellung schlickergegossener isotroper Verbundwerkstoffe auf Kupferbasis mit geringem thermischem Ausdehnungskoeffizienten und hoher elektrischer Leitfähigkeit sowie deren Verwendung.**

(57) Die Erfindung betrifft ein Verfahren zur Herstellung schlickergegossener isotroper Verbundwerkstoffe auf Kupferbasis mit geringem thermischem Ausdehnungskoeffizienten und hoher elektrischer Leitfähigkeit. Dabei wird von einem Mischschlicker ausgegangen, der eine Pulverkomponente mit einer hohen elektrischen Leitfähigkeit und eine weitere Pulverkomponente mit einem geringen thermischen Ausdehnungskoeffizienten, ein Lösemittel, einen Verflüssiger und ggf. weitere systembedingte Zusätze enthält. Der Mischschlicker wird als Grünband auf ein geeignetes Substrat vergossen, ausgebrannt, gesintert und über Kaltwalz- und Anlaßschritte zu einem massiven Band verarbeitet.
Die erfindungsgemäß schlickergegossenen Verbundwerkstoffe werden vorzugsweise zur Herstellung elektronischer Bauteile verwendet.

Fig. 4

EP 0 579 911 A2

Die Erfindung betrifft ein Verfahren zur Herstellung eines bandförmigen Kupfer-Verbundwerkstoffes aus Metallpulvern nach dem Oberbegriff des Anspruchs 1.

Die fortschreitende Miniaturisierung von elektronischen Bauteilen sowie die Entwicklung immer leistungsstärkerer Einzelkomponenten führt zu stetig wachsenden Ansprüchen an das Eigenschaftsbild der zu verarbeitenden Werkstoffe. So sind z.B. im Falle von Leiterrahmen solche Werkstoffe von Vorteil, die neben einer hohen Leitfähigkeit auch günstige Biegeeigenschaften, eine hohe Erweichungstemperatur und insbes. eine geringe thermische Ausdehnung aufweisen.

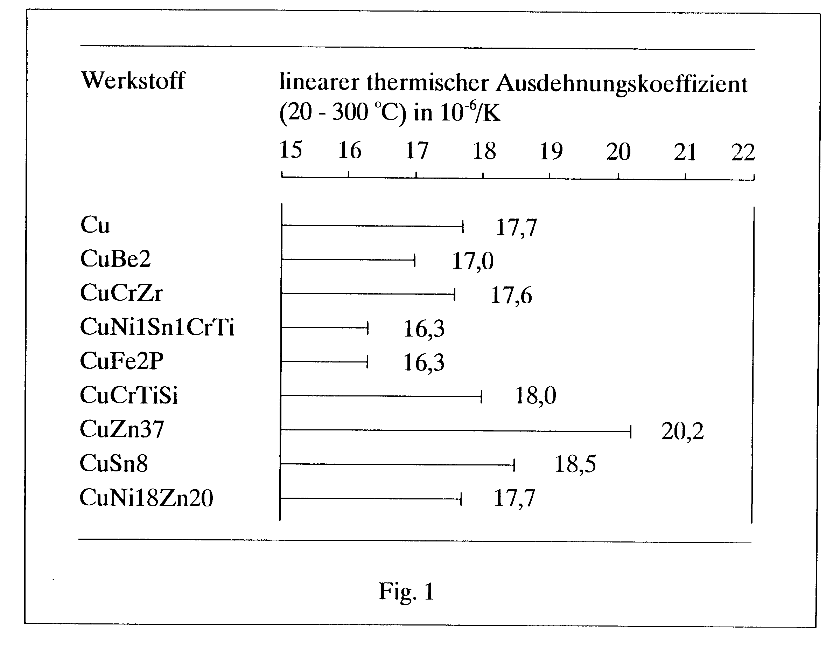

Wie Fig.1 zeigt, liegt der im Temperaturintervall zwischen 20 und 300°C bestimmte lineare thermische Ausdehnungskoeffizient von naturharten und ausscheidungsbildenden Kupferlegierungen zwischen 16 und $20 \times 10^{-6}$/K. Hingegen beträgt die Wärmeausdehnung von keramischen Komponenten auf Silizium-basis je nach Verunreinigungsgehalt und Dotierungsgrad typischerweise zwischen 2,8 und $7,3 \times 10^{-6}$/K. Dieses deutlich unterschiedliche Ausdehnungsverhalten führt bei der Montage der keramischen Elemente auf einen Leiterrahmen zu Fehlpassungen oder kann ein vorzeitiges Versagen des Bauteils bei höheren und zyklisch schwankenden Einsatztemperaturen verursachen.

Der Werkstoff FeNi42 (DIN 13917) zeichnet sich gegenüber den Kupferlegierungen durch einen wesentlich niedrigeren thermischen Ausdehnungskoeffizienten von 4,5 bis $5,5 \times 10^{-6}$/K aus.

Aufgrund seiner ausgesprochen geringen elektrischen Leitfähigkeit von lediglich 1,7 MS/m ist dieser Werkstoff jedoch nur für solche Anwendungen geeignet, bei denen keine hohen Anforderungen an die Leitfähigkeit gestellt werden.

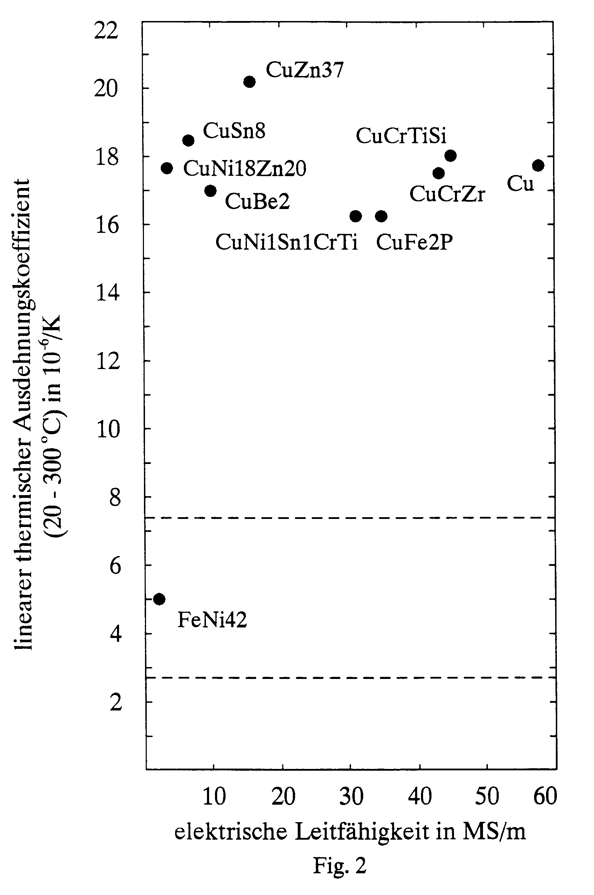

In Fig.2 sind die linearen thermischen Ausdehnungskoeffizienten und elektrischen Leitfähigkeiten von einigen als Kontaktträger eingesetzten Legierungen dargestellt. Die Auftragung verdeutlicht, daß keiner dieser schmelzmetallurgisch hergestellten Werkstoffe die Forderung nach einer gleichzeitig vorliegenden hohen Leitfähigkeit und geringen Wärmeausdehnung erfüllt.

Das US-Patent 4.158.719 beschreibt ein Verfahren zur Herstellung von pulvermetallurgischen Verbundwerkstoffen mit einem linearen thermischen Ausdehnungskoeffizienten von ca $12 \times 10^{-6}$/K. Hierzu wird eine Mischung aus einem Pulver mit einer hohen Wärmeleitfähigkeit und einem Pulver mit einer geringen Wärmeausdehnung zu einem Grünkörper verpreßt, gesintert und über mehrere Kaltwalz- und Anlaßschritte zu einem massiven Band verarbeitet. Als Komponente mit geringer Wärmeausdehnung wird eine FeNi-Legierung mit Zusätzen an Kobalt und ggf. Chrom genannt. Eisen, Nickel und Kupfer dienen als Komponenten mit hoher thermischer Leitfähigkeit. Ein wesentlicher Nachteil des Verfahrens liegt jedoch darin begründet, daß die Pulver nicht auf kontinuierlichem Wege, sondern chargenweise unter sehr hohem Druck gepreßt und auch in kleinen Chargen gesintert werden müssen. Um eine hinreichende Konsolidierung des Verbundes zu erzielen, müssen sehr hohe Sintertemperaturen gewählt werden. So wird z.B. für die Legierung Cu(FeNi42)50 eine Sintertemperatur von 1010°C bei einer Haltezeit von 3 bis 60 min vorgeschlagen. Es ist jedoch bekannt, daß sich mit zunehmender Temperatur Eisen unter Bildung eines Cu/Fe-Mischkristalls in Kupfer einlöst und eine dramatische Abnahme der Leitfähigkeitseigenschaften des Kupfers bewirkt. Eigene Untersuchungen haben gezeigt, daß die elektrische Leitfähigkeit eines Cu(FeNi42)50-Verbundes nach einer Kurzzeitglühung bei 1000°C auf Werte unter 5 MS/m abfällt und die Forderung nach einer geringen Wärmeausdehnung und gleichzeitig hohen Leitfähigkeit von diesen Verbunden nicht erfüllt werden kann.

Das EP-Patent 0.144.959 versucht, das zuvor genannte Problem zu umgehen, indem auf die Durchführung einer Sinterbehandlung gänzlich verzichtet wird. Gemäß diesem Patent wird eine Pulvermischung aus mit Aluminiumoxid dispersionsverfestigtem Kupfer bzw. elementarem Kupfer oder auch Bronze mit einer FeNi- bzw. FeNiCo-Legierung oder auch elementarem Molybdän oder Wolfram in ein Hüllrohr gefüllt und zu einer Stange warmgepreßt. Bei diesem Prozeß muß allerdings berücksichtigt werden, daß der Preßvorgang selbst zwar bei Temperaturen von 450 bis 510°C erfolgt, jedoch eine Vorwärmtemperatur der Preßbolzen von ca 840°C und eine Vorwärmzeit von 45 min empfohlen wird. Unseren Untersuchungen zufolge, muß diese thermische Behandlung hinsichtlich ihrer Auswirkung auf die Leitfähigkeitseigenschaften eines Cu- und Fe-haltigen Verbundes einem Sinterprozeß gleichgesetzt werden. Dementsprechend wird die an einem nach diesem Verfahren gefertigten Draht der Zusammensetzung Cu(FeNi36)50 bestimmte elektrische Leitfähigkeit auch nur mit 3,6 MS/m angegeben. Die bei 20°C ermittelte Wärmeausdehnung beträgt $13,9 \times 10^{-6}$/K. Somit wird deutlich, daß auch diese Werkstoffe die Forderung nach einer geringen thermischen Ausdehnung und gleichzeitig hohen Leitfähigkeit nicht erfüllen. Für die Herstellung von breiteren Bandstrukturen ist dieses Verfahren zudem ungeeignet, da in jedem Falle von einem verschweißten Preßbolzen ausgegangen wird und nur Stangen, Drähte oder sehr schmale Streifen gefertigt werden können.

Die Herstellung von flachen Verbundstrukturen aus schmelzmetallurgischen Ausgangskomponenten wird im US-Patent 4.283.464 beschrieben. Gemäß diesem Patent wird z.B. eine Kupferplatte mit günstigen Leitfähigkeitseigenschaften zwischen zwei FeNi42-Stückbleche mit geringer Wärmeausdehnung gelegt und durch Pressen unter hohem Druck oder durch Walzen ein massiver 3-Schicht-Verbund erzeugt. Die FeNi42-Stückbleche müssen zuvor mit einer großen Anzahl von Durchgangsbohrungen versehen werden, damit das Kupfer im anschließenden Preß- oder Walzvorgang in diese Bohrungen fließt und die Löcher vollständig ausfüllt. Derart gefertigte Verbundstrukturen bringen jedoch außer dem aufwendigen Herstellungsverfahren einen weiteren schwerwiegenden Nachteil mit sich. So liegen an der Oberfläche makroskopisch grobe Bereiche mit guter und schlechter Leitfähigkeit bzw. mit hoher und geringer Wärmeausdehnung nebeneinander vor, d.h. die geforderte Isotropie der Volumen- und insbes. Oberflächeneigenschaften des Verbundes wird von einer solchen Struktur auf keinen Fall erfüllt.

Die EP-OS 0.437.656 beschreibt ein modifiziertes Verfahren zur Herstellung von 3-Schicht-Verbunden mit geringer Wärmeausdehnung. Jeweils zwei Kupferplatten und eine FeNi-Platte mit Nickelgehalten zwischen 32 und 40 Gew.-% werden unabhängig voneinander zu Bändern warmgewalzt. Das FeNi-Band wird dann mit einer Vielzahl von Durchgangsbohrungen versehen und zwischen die beiden Kupferbänder gelegt. Die losen Schichten werden bei Temperaturen zwischen 750 und 850°C für 10 min angesintert und anschließend warm- bzw. kaltgewalzt. Diese Verbundstruktur besitzt zwar an der Oberfläche die günstigen Leitfähigkeitseigenschaften des Kupfers, weist jedoch aufgrund ihres FeNi-Kernes trotz der eingewalzten Kupferstifte keine isotropen Volumeneigenschaften auf. Der aus Messungen parallel und senkrecht zur Bandebene ermittelte Anisotropiefaktor wird mit Werten zwischen 0,9 und 2 angegeben. An den Cu/FeNi-Grenzflächen muß zudem bei zyklischer thermischer Beanspruchung aufgrund des unterschiedlichen Ausdehnungsverhaltens der Werkstoffe mit dem Auftreten von ausgeprägten Spannungszuständen gerechnet werden.

Die Ausführungen verdeutlichen, daß gewalzte 3-Schicht-Verbundstrukturen gegenüber pulvermetallurgischen Verbunden wesentliche Nachteile aufgrund ihrer stark anisotropen Ausdehnungs- und Leitfähigkeitseigenschaften sowie des aufwendigen Herstellungsprozesses zeigen. Hingegen ergeben sich bei der konventionellen Herstellung von Pulververbunden zum Teil nicht zu bewältigende Schwierigkeiten bei der Verarbeitung der unterschiedlich gearteten Metallpulver sowie aufgrund von leitfähigkeitserniedriegenden Reaktionsvorgängen während der Sinterbehandlung.

Der Erfindung liegt daher die Aufgabe zugrunde, ein Verfahren der genannten Art so auszugestalten, daß insbes. homogene und isotrope Kupfer-Verbundwerkstoffe erzielt werden, die sich sowohl durch ihre geringe Wärmeausdehnung als auch durch eine hohe elektrische Leitfähigkeit auszeichnen.

Die Aufgabe wird erfindungsgemäß dadurch gelöst, daß von einem Mischschlicker ausgegangen wird, der die Metallpulver-Komponenten, ein Lösemittel, einen Verflüssiger und ggf. weitere systembedingte Zusätze enthält, daß der Mischschlicker als Grünband auf ein geeignetes Substrat vergossen wird und daß das Grünband vor dem Sintern im getrockneten Zustand ausgebrannt wird.

Schlickergegossene Verbundstrukturen weisen einen homogenen und isotropen Gefügeaufbau auf. Über einen Mischschlicker können beliebige Metallpulver unabhängig von ihrer Teilchengröße, Werkstoffdichte, geometrischen Ausbildung und Fließfähigkeit zu einem handhabbaren endabmessungsnahen Grünband verarbeitet werden. Die Sinterparameter können so eingestellt werden, daß sich die resultierenden Verbundstrukturen durch eine geringe thermische Ausdehnung und eine gleichzeitig hohe Leitfähigkeit auszeichnen.

Als Schlicker bezeichnet man ein kolloidchemisches System, welches sich im einfachsten Falle aus einem Pulver, einem flüssigen Suspensionsmedium (Lösemittel) sowie einem weiteren Additiv, dem Verflüssiger, zusammensetzt.

Das Wissen um die Herstellung und Verarbeitung dieser Systeme ist bereits sehr alt. Heute wird das Schlickergießverfahren zur Herstellung von Formteilen und dünnen Folien aus keramischen Pulvern genutzt, jedoch wurde auch schon über die Verarbeitung von Metallen insbes. Refraktärpulvern berichtet (z.B. DE-PS 627.980).

Gegenüber anderen Formgebungsverfahren stellt das Schlickergießen eine interessante Alternative dar. Ein wesentlicher Unterschied liegt in der drucklosen und richtungsunabhängigen Konsolidierung der Pulver zu handhabbaren Grünlingen, die durch geeignete Folgeprozesse zu hochverdichteten Formkörpern oder Bändern weiterverarbeitet werden. Im Gegensatz zu schmelzmetallurgischen Verfahren können segregationsfreie oder zumindest segregationsarme sowie konventionell nicht legierbare Werkstoffe und Werkstoffkombinationen hergestellt werden. Neben gezielten Restporositäten lassen sich durch die Wahl geeigneter Ausgangspulver sehr feine Korngrößen im Gefüge einstellen. Anwendungsspezifische Eigenschaftskombinationen können durch die Verarbeitung unterschiedlich zusammengesetzter Schlicker erzielt werden.

Die vorliegende Erfindung beruht auf dem Gedanken, einen sogenannten Mischschlicker aus zwei unterschiedlichen Metallpulvern aufzubereiten und unter systemspezifischen Parametern zu einem endabmessungsnahen Band zu verarbeiten. Bei der einen Komponente handelt es sich vorzugsweise um elementares Kupferpulver, das sich durch seine hohe elektrische und thermische Leitfähigkeit von über 58 MS/m bzw. annähernd 400 W/mK auszeichnet. Als zweite Pulverkomponente eignen sich insbes. Werkstoffe mit einem geringen thermischen Ausdehnungskoeffizienten wie z.B. Molybdän, Wolfram und FeNi-Legierungen mit bevorzugten Nickelgehalten zwischen 32 und 46 Gew.-%. So weist die unter der Bezeichnung Alloy 42 bekannte Legierung FeNi42 im Temperaturbereich zwischen 20 und 300°C einen linearen Ausdehnungskoeffizienten von 4,5 bis $5,5 \times 10^{-6}$/K auf. Für Wolfram beträgt dieser Wert $4,3 \times 10^{-6}$/K. Die Pulverteilchen sollten vorzugsweise von sphärischer bis sphäroider Gestalt sein und in Durchmessern von weniger als 150 $\mu$m vorliegen. Es hat sich gezeigt, daß sich die o.g. Komponenten bei mittleren Teilchengrößen von ca 20 $\mu$m besonders günstig in einem Mischschlicker aufbereiten lassen. Der Pulvergehalt kann je nach Zusammensetzung des Schlickersystems zwischen 70 und 95 Gew.-% betragen, wobei die einzelnen Pulverkomponenten gegenseitig vollständig substituierbar sind.

Organisch aufgebaute Schlicker enthalten Lösemittel, die den Stoffklassen der Kohlenwasserstoffe, Alkohole, Ketone und Ester angehören können oder ggf. über ihre Stickstoffhaltigkeit charakterisierbar sind. Die Lösemittel können auch in Mischungen vorliegen und werden dem Schlicker in Gehalten zwischen 5 und 30 Gew.-% zugegeben. Die o.g. Pulverkomponenten lassen sich jedoch auch in wäßrigen Schlickern, d.h. unter Verwendung von destilliertem Wasser als Lösemittel aufbereiten.

Die Wahl des Verflüssigers richtet sich in erster Linie nach der Verträglichkeit mit dem Lösemittel. Geeignete Verflüssiger können den Stoffklassen der Polyether, Polyester, Paraffine, Polyole, Polyamide, Polyimide, Polyamine, Polycarbonate und Polyelektrolyte angehören oder ggf. auch Mischungen aus diesen Stoffklassen darstellen. Die verflüssigende Substanz ist typischerweise in Gehalten zwischen 0,1 und 5 Gew.-% im Schlicker enthalten.

Bei bestimmten Schlickerzusammensetzungen ist es ratsam, eigenschafts- oder prozeßoptimierende Zuschläge wie z.B. ein Desoxidationsmittel bei wäßrigen Schlickern zuzugeben. Diese Zusätze sollten jedoch in Gehalten von höchstens 3 Gew.-% im Schlicker enthalten sein.

Die einzelnen Schlickerkomponenten werden so aufeinander abgestimmt, daß die eingebrachten Metallpulver weder an die Oberfläche des Lösemittels aufschwimmen noch auf den Grund des Mischgefäßes absinken oder agglomerieren. Eine über längere Zeiten stabile und homogene Suspension wird erzielt, indem der Schlicker für wenige Minuten unter Verwendung von Zirkonoxid-Kugeln bei Raumtemperatur attritiert wird.

Der in einen Gießbehälter umgefüllte Schlicker wird gleichmäßig und blasenfrei auf ein umlaufendes Band oder einen anderen Träger vergossen und nach einer kurzen Trocknungszeit von wenigen Sekunden bis zu einigen Minuten als flexibles Grünband aufgehaspelt. Dichte, Dicke und Breite des resultierenden Bandes werden durch die Zusammensetzung des Schlickers und insbes. durch die Gießparameter bestimmt. Die Dicke der Bänder beträgt zwischen 0,1 und 3 mm, bevorzugt jedoch 1 mm. Ein Besäumen des Bandes im Grünzustand ist ratsam, da die Kantenabfälle aufgemahlen und in einem neuen Schlickeransatz wieder verwertet werden können.

In einem thermischen Ausbrennprozeß werden die organischen Zusätze rückstandsfrei aus dem Grünband ausgetrieben. Im Falle der Cu/FeNi-Bänder wird das Ausbrennen bevorzugt bei Temperaturen unter 700°C für wenige Minuten ausgeführt. Bei den Cu/Mo- und Cu/W-Bändern können die Ausbrennparameter ohne jede Einschränkung dem thermischen Verhalten des jeweiligen Verflüssigers angepaßt werden.

Während des sich anschließenden Sinterprozesses erfährt das ausgebrannte Band aufgrund von Festkörper-Diffusionsvorgängen eine deutliche Verdichtung. Bei der Wärmebehandlung der Cu/FeNi-Bänder muß besonderes Augenmerk auf die Temperaturführung gelegt werden, da hinreichend bekannt ist, daß sich Eisen bei höheren Temperaturen unter Bildung eines Cu/Fe-Mischkristalls im Kupfer einlöst und dadurch einen deutlichen Abfall der elektrischen Leitfähigkeit des Kupfers verursacht. Es hat sich jedoch gezeigt, daß eine schnell angesteuerte Sintertemperatur von 800°C und eine sofortige Abkühlung mit ca 50 - 200°C/min einerseits zur Konsolidierung des Bandes ausreicht, andererseits die Leitfähigkeit des Werkstoffes nicht zu stark erniedrigt. Sintertemperaturen unter 750°C erweisen sich als nicht zweckmäßig, da bei diesen Temperaturen keine Verdichtung des Pulververbundes erfolgt und das Sinterband für die weiteren Folgebehandlungen noch nicht handhabbar bzw. noch zu spröde ist. Temperaturen über 900°C sollten aufgrund des Steilabfalls der Leitfähigkeitseigenschaften ebenfalls vermieden werden.

Im Falle der Cu/Mo- und Cu/W-Bänder können Sintertemperaturen bis zu 1000°C problemlos realisiert werden, da diese Elemente im festen Zustand keine gegenseitige Löslichkeit aufweisen. Die Haltezeit beträgt typischerweise zwischen wenigen Minuten und einer Stunde.

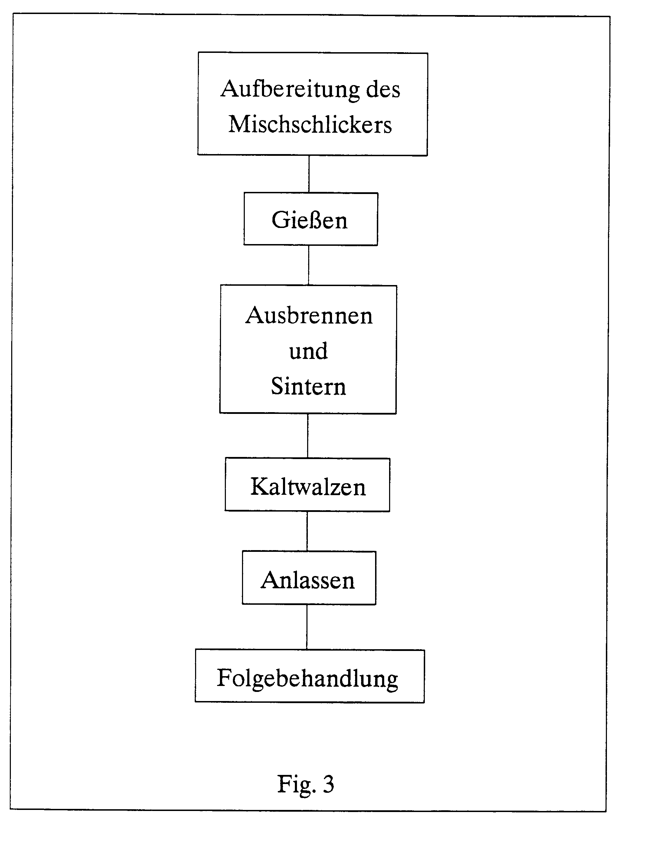

Die resultierenden Sinterbänder können aufgehaspelt und durch nachfolgende Prozesse wie Kaltwalzen und Anlassen sowie Längs- und/oder Querteilen auf die gewünschten Eigenschaften und Formate eingestellt werden. In Fig.3 ist die Fertigungsabfolge der zuvor beschriebenen Teilschritte skizziert.

Aufgrund ihrer ausgezeichneten Eigenschaften werden die erfindungsgemäß hergestellten Verbundwerkstoffe bevorzugt zur Herstellung folgender Gegenstände verwendet:

a) ein Systemträger zur elektrischen Verbindung mit elektronischen Komponenten von integrierten Schaltkreisen aus Silizium oder Keramik,

b) ein Kontaktverbinder für elektrische und elektronische Anwendungen,

c) eine stromführende Feder,

d) eine Schaltkomponente oder

e) eine Wärmesenke.

Die Erfindung wird anhand der folgenden Ausführungsbeispiele näher erläutert, in denen insbes. auf die Eigenschaften der verschiedenen Bandwerkstoffe näher eingegangen wird. Es zeigen:

Tabelle 1:

Einige Eigenschaften von schlickergegossenen Verbundbändern der Zusammensetzungen Cu(FeNi42)-30, Cu(FeNi42)50 und Cu(FeNi42)70 in unterschiedlichen Festigkeitsniveaus.

Tabelle 2:

Einige Eigenschaften von schlickergegossenen Verbundbändern der Zusammensetzungen CuW40, CuW50 und CuW60 in unterschiedlichen Festigkeitsniveaus.

Tabelle 3:

Einige Eigenschaften von schlickergegossenen Verbundbändern der Zusammensetzungen CuMo30, CuMo40 und CuMo50 in unterschiedlichen Festigkeitsniveaus.

Fig.4:

Eine vergleichende Darstellung der erfindungsgemäßen schlickergegossenen Verbundwerkstoffe mit schmelzmetallurgisch hergestellten Kontaktträgerwerkstoffen hinsichtlich thermischer Ausdehnung und elektrischer Leitfähigkeit.

Beispiel 1:

Es wurden durch Gasverdüsung hergestellte Cu- und FeNi42-Pulver in einem Mischungsverhältnis von 70 Gew.-% Cu zu 30 Gew.-% FeNi42 in einem Mischschlicker aufbereitet.

Die Schlickerzusammensetzung wurde wie folgt festgelegt:

85,0 Gew.-% Metallpulver

13,5 Gew.-% Lösemittel

1,5 Gew.-% Verflüssiger

Als Lösemittel diente Ethansäure-n-Butylester. Als Verflüssiger wurde ein Alkylen-Polyether-Copolymerisat zugegeben.

Der für wenige Minuten attritierte Schlicker wurde zu einem 0,8 mm dicken Grünband vergossen, ausgebrannt und bei 800°C ohne Haltezeit unter Formiergas gesintert.

Im Anschluß wurde das Sinterband mit einem Umformgrad von 50 % an 0,4 mm Dicke kaltgewalzt, zwischengeglüht und mit einem Umformgrad von 30 % an 0,28 mm Dicke erneut kaltgewalzt. Bei einer abschließenden Anlaßbehandlung werden die gewünschten Eigenschaftskombinationen eingestellt.

Die an den Bändern in unterschiedlichen Festigkeitsniveaus ermittelten Eigenschaften sind in Tabelle 1 zusammengefaßt. Durch den Zusatz von 30 Gew.-% FeNi42-Legierungspulver wird der im Temperaturbereich zwischen 20 und 300°C bestimmte lineare thermische Ausdehnungskoeffizient des Kupfers von 17,7 auf ca 10,0 bis $12,8 \times 10^{-6}$/K reduziert. Die bei 20°C ermittelte elektrische Leitfähigkeit beträgt zwischen 30 und 35 MS/m (52 bis 60 % IACS) und verhält sich aufgrund des homogenen und feinkörnigen Gefügeaufbaus in allen Raumrichtungen isotrop.

Beispiel 2:

Es wurde der folgende Schlicker aufbereitet und zu einem 1 mm dicken Grünband vergossen:

87,5 Gew.-% Metallpulver;

Cu/FeNi42-Verhältnis: 50/50 Gew.-% 10,5 Gew.-% Lösemittel; Tetrahydrofuran
2,0 Gew.-% Verflüssiger; Polyalkylenglycolen-Block-Copolymerisat.

Das Grünband wurde bei 500°C ausgebrannt und anschließend bei 810°C ohne Haltezeit gesintert, mit einem Umformgrad von 50 % an 0,5 mm kaltgewalzt, zwischengeglüht und erneut um 50 % an 0,25 mm kaltgewalzt.

Die an unterschiedlichen Festigkeitsniveaus ermittelten Eigenschaften sind ebenfalls in Tabelle 1 aufgeführt. Die Zugabe von 50 Gew.-% FeNi42 erniedrigt den Ausdehnungskoeffizienten von 17,7 auf ca 8,6 bis $10,9 \times 10^{-6}$/K. Im Temperaturbereich zwischen 20 und 450°C beträgt die thermische Ausdehnung zwischen 10,2 und $12,1 \times 10^{-6}$/K, wobei diese Werte deutlich unter der an einem unlegierten FeNi42-Werkstoff ermittelten Ausdehnung von annähernd $15 \times 10^{-6}$/K liegen. Mit einer elektrischen Leitfähigkeit von 15 bis 21 MS/m (26 bis 36 % IACS) weist dieser Werkstoff eine bis zu 12mal höhere Leitfähigkeit als Alloy 42 auf.

Beispiel 3:

Es wurde der folgende Schlicker aufbereitet und zu einem 0,6 mm dicken Grünband vergossen:
82,0 Gew.-% Metallpulver; Cu/FeNi42-Verhältnis: 30/70 Gew.-%
17,0 Gew.-% Lösemittel; 1,4-Dioxolan
1,0 Gew.-% Verflüssiger; Alkylen-Polyether-Copolymerisat.

Das Grünband wurde ausgebrannt und bei 800°C für 5 min unter Formiergas gesintert. Nach Durchführung der bereits oben beschriebenen Fertigungsschritte lagen Bandabschnitte mit einer Dicke von 0,15 mm in unterschiedlichen Festigkeitszuständen vor.

In Tabelle 1 sind die an den Bändern ermittelten Eigenschaften wiedergegeben. Die thermische Ausdehnung im Temperaturbereich zwischen 20 und 300°C bzw. 20 und 450°C beträgt 8,0 bis 9,5 und 8,7 bis $11,0 \times 10^{-6}$/K. Der Werkstoff zeigt eine elektrische Leitfähigkeit von ca 10 bis 12 MS/m und entspricht somit der Legierung CuBe2 (DIN 17666) im ausgehärteten Zustand.

Beispiele 4, 5 und 6:

Es wurden die folgenden Schlicker aufbereitet und zu Grünbändern mit einer Dicke von jeweils 1 mm vergossen:
85,0 Gew.-% Metallpulver; Cu und W
12,5 Gew.-% Lösemittel, destilliertes Wasser
1,5 Gew.-% Verflüssiger; $[-CH_2-CHX-]_n$-Polyvinyl
X...$NR_1R_2$
$R_1$, $R_2$...Carbonylrest
1,0 Gew.-% Weichmacher; Glyzerin
Es wurden Cu/W-Verhältnisse von 60/40, 50/50 und 40/60 Gew.-% gewählt.

Die Grünbänder wurden auf 500°C erwärmt und rückstandsfrei ausgebrannt. Der Sinterprozeß erfolgte bei 1000°C für 1 h unter reduzierender Atmosphäre. Nach Durchführung der bereits beschriebenen Fertigungsschritte lagen Bandabschnitte mit einer Dicke von 0,25 mm in verschiedenen Festigkeiten vor.

Wie Tabelle 2 zeigt, weisen die Cu/W-Verbundwerkstoffe im Temperaturbereich zwischen 20 und 300°C lineare Ausdehnungskoeffizienten von ca 10,0 - $14,7 \times 10^{-6}$/K auf. Im Temperaturintervall zwischen 20 und 450°C liegen nahezu identische Werte vor. Ihre elektrische Leitfähigkeit variiert ebenfalls in Abhängigkeit vom Wolframgehalt und dem eingestellten Festigkeitsniveau zwischen 28 und 47 MS/m (48 bis 81 % IACS).

Beispiele 7, 8 und 9:

Es wurden die folgenden Schlicker aufbereitet und zu Grünbändern mit einer Dicke von jeweils 0,8 mm vergossen:
85,0 Gew.-% Metallpulver; Cu und Mo
13,5 Gew.-% Lösemittel; Ethansäure-n-Butylester
1,5 Gew.-% Verflüssiger; Polyalkylenglycolen-Block-Copolymerisat
Es wurden Cu/Mo-Verhältnisse von 70/30, 60/40 und 50/50 Gew.-% gewählt.

Die Grünbänder wurden an Luft ausgebrannt, für 1 h bei 1000°C reduzierend gesintert und an 0,2 mm abgewalzt.

6

Tabelle 3 zeigt, daß der CuMo30-Verbund bei einer elektrischen Leitfähigkeit von bis zu 48 MS/m (83 % IACS) einen thermischen Ausdehnungskoeffizienten von 11,6 bis $14,6 \times 10^{-6}$/K aufweist. Ein aus einem CuMo50-Mischschlicker hergestelltes Band besitzt eine Leitfähigkeit, die der der Legierung CuFe2P (DIN 17666) entspricht und zeichnet sich zudem gegenüber diesem häufig für Leiterrahmen verwendeten Werkstoff durch eine wesentlich geringere Wärmeausdehnung von lediglich 5,8 bis $10,8 \times 10^{-6}$/K (20 bis 450 °C) aus.

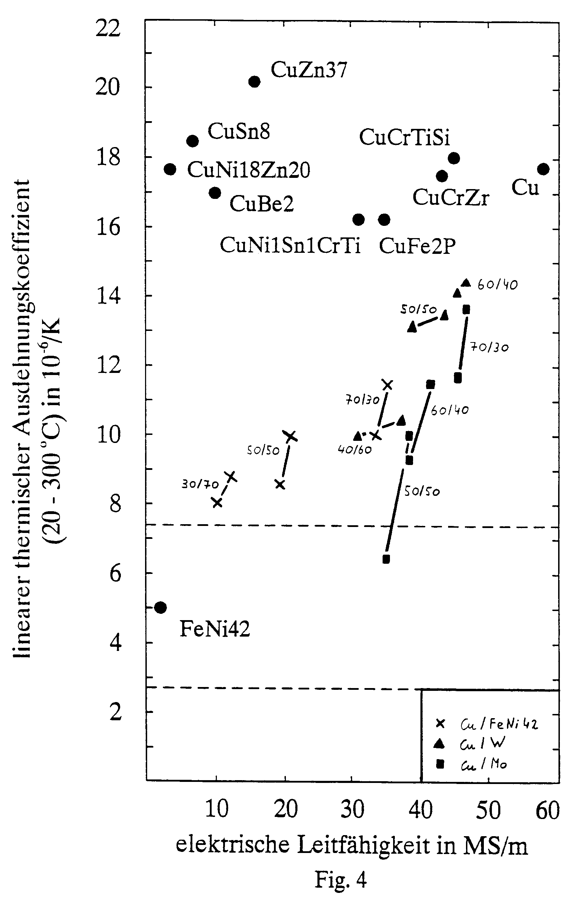

Die in den Ausführungsbeispielen 1 bis 9 beschriebenen Verbundwerkstoffe sind in Fig.4 hinsichtlich ihrer bestmöglichen thermischen Ausdehnung und elektrischen Leitfähigkeit einigen schmelzmetallurgisch hergestellten Kupferlegierungen gegenübergestellt.

| Werkstoff | Zustand | HV0,3 | lin.therm.Ausdehnungskoeffizient (20-300°C) in $10^{-6}$/K | lin.therm.Ausdehnungskoeffizient (20-450°C) in $10^{-6}$/K | elektr. Leitfähigkeit in MS/m | elektr. Leitfähigkeit in % IACS |
|---|---|---|---|---|---|---|
| Cu(FeNi42)30 | 1 | 140-160 | 10,0 - 11,5 | 12,1 - 13,4 | 30 - 33 | 52 - 57 |
| Cu(FeNi42)30 | 2 | 85-105 | 11,4 - 12,8 | 12,6 - 13,8 | 32 - 35 | 55 - 60 |
| Cu(FeNi42)50 | 1 | 150-180 | 8,6 - 9,5 | 10,2 - 11,0 | 15 - 19 | 26 - 33 |
| Cu(FeNi42)50 | 2 | 135-155 | 9,9 - 10,9 | 11,2 - 12,1 | 18 - 21 | 31 - 36 |
| Cu(FeNi42)70 | 1 | 190-220 | 8,0 - 8,4 | 8,7 - 9,3 | ca. 10 | ca. 17 |
| Cu(FeNi42)70 | 2 | 170-200 | 8,7 - 9,5 | 10,1 - 11,0 | 10 - 12 | 17 - 21 |

Tabelle 1

| Werkstoff | Zustand | HVO,3 | lin.therm.Ausdehnungskoeffizient (20-300°C) in $10^{-6}$/K | lin.therm.Ausdehnungskoeffizient (20-450°C) in $10^{-6}$/K | elektr. Leitfähigkeit in MS/m | elektr. Leitfähigkeit in % IACS |
|---|---|---|---|---|---|---|
| CuW40 | 1 | 125-140 | 14,1   14,6 | 14,5 - 14,7 | 42 - 45 | 72 - 78 |
| CuW40 | 2 | 80- 95 | 14,3 - 14,7 | 14,5 - 14,8 | 45 - 47 | 78 - 81 |
| CuW50 | 1 | 140-160 | 13,1 - 13,5 | 13,3 - 13,6 | 36 - 39 | 62 - 67 |
| CuW50 | 2 | 95-115 | 13,4 - 13,9 | 13,6 - 14,0 | 40 - 43 | 69 - 74 |
| CuW60 | 1 | 150-180 | 10,0 - 12,6 | 9,7   12,1 | 28 - 31 | 48 - 53 |
| CuW60 | 2 | 100-125 | 10,4 - 12,2 | 9,8 - 12,0 | 33 - 37 | 57 - 64 |

Tabelle 2

| Werkstoff | Zustand | HV0,3 | lin.therm.Ausdehnungskoeffizient (20–300°C) in $10^{-6}$/K | lin.therm.Ausdehnungskoeffizient (20–450°C) in $10^{-6}$/K | elektr. Leitfähigkeit in MS/m | elektr. Leitfähigkeit in % IACS |
|---|---|---|---|---|---|---|
| CuMo30 | 1 | 125–145 | 11,6 – 12,1 | 11,8 – 13,4 | 42 – 45 | 72 – 76 |
| CuMo30 | 2 | 65– 85 | 13,7 – 14,6 | 13,6 – 14.4 | 43 – 48 | 74 – 83 |
| CuMo40 | 1 | 140–165 | 9,2 – 10,8 | 9,1 – 11,2 | 34 – 38 | 59 – 66 |
| CuMo40 | 2 | 100–120 | 11,4 – 12,3 | 11,5 – 12,1 | 37 – 41 | 64 – 71 |
| CuMo50 | 1 | 180–200 | 6,4 – 7,6 | 5,8 – 7,6 | 33 – 35 | 57 – 60 |
| CuMo50 | 2 | 140–170 | 10,0 – 10,9 | 9,4 – 10,8 | 35 – 38 | 60 – 66 |

Tabelle 3

## Patentansprüche

1. Verfahren zur Herstellung eines bandförmigen Kupfer-Verbundwerkstoffes aus Metallpulver, wobei der Werkstoff aus einer Pulverkomponente mit einer hohen elektrischen Leitfähigkeit und einer weiteren Pulverkomponente mit einem geringen thermischen Ausdehnungskoeffizienten besteht, wobei aus den Pulverkomponenten ein Grünkörper hergestellt wird, der gesintert und über Kaltwalz- und Anlaßschritte zu einem massiven Band verarbeitet wird,
dadurch gekennzeichnet,
daß von einem Mischschlicker ausgegangen wird, der die Metallpulver-Komponenten, ein Lösemittel, einen Verflüssiger und gegebenenfalls weitere systembedingte Zusätze enthält,
daß der Mischschlicker als Grünband auf ein geeignetes Substrat vergossen wird und
daß das Grünband vor dem Sintern im getrockneten Zustand ausgebrannt wird.

2. Verfahren nach Anspruch 1,
dadurch gekennzeichnet,
daß das Metallpulver im Mischschlicker in Gehalten zwischen 70 und 95 Gew.-% enthalten ist.

3. Verfahren nach Anspruch 1 oder 2,
dadurch gekennzeichnet,
daß Kupferpulver als hochleitfähige Komponente und vorlegiertes Eisen-Nickel(FeNi)-Pulver oder Molybdän(Mo)- oder Wolfram(W)-Pulver als Komponente geringer Wärmeausdehnung gemischt werden.

4. Verfahren nach Anspruch 3,
dadurch gekennzeichnet,
daß die FeNi-Legierung zwischen 32 und 46 Gew.-% Ni enthält.

5. Verfahren nach Anspruch 4,
dadurch gekennzeichnet,
daß die FeNi-Legierung etwa 42 Gew.-% Ni enthält.

6. Verfahren nach einem oder mehreren der Ansprüche 1 bis 5,
dadurch gekennzeichnet,
daß die im Mischschlicker enthaltenen Metallpulverkomponenten von sphärischer bis sphäroider Gestalt sind und mit Teilchengrößen < 150 um vorliegen.

7. Verfahren nach Anspruch 6,
dadurch gekennzeichnet,
daß die im Mischschlicker enthaltenen Metallpulverkomponenten mit Teilchengrößen < 50 um vorliegen.

8. Verfahren nach einem oder mehreren der Ansprüche 1 bis 7,
dadurch gekennzeichnet,
daß das Lösemittel im Mischschlicker in Gehalten zwischen 5 und 30 Gew.-% enthalten ist.

9. Verfahren nach Anspruch 8,
dadurch gekennzeichnet,
daß das enthaltene Lösemittel den Stoffklassen der Kohlenwasserstoffe, Alkohole, Ketone und Ester angehört, gegebenenfalls über seine Stickstoffhaltigkeit charakterisierbar ist oder aus destilliertem Wasser besteht.

10. Verfahren nach einem oder mehreren der Ansprüche 1 bis 9,
dadurch gekennzeichnet,
daß der Verflüssiger im Mischschlicker in Gehalten zwischen 0,1 und 5 Gew.-% enthalten ist.

11. Verfahren nach Anspruch 10,
dadurch gekennzeichnet,
daß der enthaltene Verflüssiger den Stoffklassen der Polyether, Polyester, Paraffine, Polyole, Polyamide, Polyimide, Polyamine, Polycarbonate und Polyelektrolyte angehört oder gegebenenfalls eine Mischung aus diesen Stoffklassen darstellt.

**12.** Verfahren nach einem oder mehreren der Ansprüche 1 bis 11,
dadurch gekennzeichnet,
daß die systembedingten Zusätze im Mischschlicker in Gehalten von maximal 3 Gew.-% enthalten sind.

**13.** Verfahren nach einem oder mehreren der Ansprüche 1 bis 12,
dadurch gekennzeichnet,
daß das Grünband bis zu einer Dicke D = 0,1 - 3 mm auf das Substrat vergossen wird.

**14.** Verfahren nach einem oder mehreren der Ansprüche 1 bis 13,
dadurch gekennzeichnet,
daß das vergossene Grünband bei Temperaturen zwischen 500 und 700 °C rückstandsfrei ausgebrannt wird.

**15.** Verfahren nach einem oder mehreren der Ansprüche 1 bis 14,
dadurch gekennzeichnet,
daß das ausgebrannte Band bei Temperaturen zwischen 750 und 1000 °C für wenige Sekunden bis zu etwa 2 Stunden unter reduzierender Atmosphäre gesintert wird.

**16.** Verfahren nach Anspruch 15,
dadurch gekennzeichnet,
daß die Zieltemperatur im Falle von Sintertemperaturen zwischen 750 und 850 °C mit sehr hohen Aufheizraten von bis zu 50 °C/min angesteuert wird.

**17.** Verfahren nach Anspruch 15 oder 16,
dadurch gekennzeichnet,
daß das Sinterband im Falle von Sintertemperaturen zwischen 750 und 850 °C nach Ablauf der Sinterzeit mit sehr hohen Abkühlraten von bis zu 200 °C/min auf Temperaturen unter 500 °C abgekühlt wird.

**18.** Verfahren nach einem oder mehreren der Ansprüche 1 bis 17,
dadurch gekennzeichnet,
daß die Restporosität des Sinterbandes durch Kaltwalzen vollständig beseitigt wird.

**19.** Verfahren nach einem oder mehreren der Ansprüche 1 bis 18,
dadurch gekennzeichnet,
daß durch Kaltwalzen und Anlassen eine elektrische Leitfähigkeit zwischen 10 und 48 MS/m und ein linearer thermischer Ausdehnungskoeffizient zwischen 5,8 und 14,8 x 10 $^{-6}$/K eingestellt werden.

**20.** Verwendung eines nach dem Verfahren nach einem oder mehreren der Ansprüche 1 bis 19 hergestellten, schlickergegossenen Verbundwerkstoffes zur Herstellung eines der nachstehenden Gegenstände:
a) ein Systemträger zur elektrischen Verbindung mit elektronischen Komponenten von integrierten Schaltkreisen aus Silizium oder Keramik,
b) ein Kontaktverbinder für elektrische und elektronische Anwendungen,
c) eine stromführende Feder,
d) eine Schaltkomponente oder
e) eine Wärmesenke.

| Werkstoff | linearer thermischer Ausdehnungskoeffizient (20 - 300 °C) in $10^{-6}$/K |
|---|---|
| | 15   16   17   18   19   20   21   22 |
| Cu | 17,7 |
| CuBe2 | 17,0 |
| CuCrZr | 17,6 |
| CuNi1Sn1CrTi | 16,3 |
| CuFe2P | 16,3 |
| CuCrTiSi | 18,0 |
| CuZn37 | 20,2 |
| CuSn8 | 18,5 |
| CuNi18Zn20 | 17,7 |

Fig. 1

Fig. 2

Aufbereitung des
Mischschlickers

Gießen

Ausbrennen
und
Sintern

Kaltwalzen

Anlassen

Folgebehandlung

Fig. 3

Fig. 4